# EUROPEAN PATENT APPLICATION

(11) **EP 4 471 820 A1**
(43) Date of publication of application: **04.12.2024**
(21) Application number: 23176703.9
(22) Date of filing: 01.06.2023
(51) Int. Cl.: H01J 37/22, H01J 37/26

(54) **METHODS FOR THREE-DIMENSIONAL TOMOGRAPHY OF ELONGATED SAMPLES**

(71) Applicant: FEI Company, Hillsboro, OR 97124-5793 (US)
(72) Inventor: FRANKEN, Erik Michiel, 5651GG Eindhoven (NL); VARSLOT, Trond K., 5651GG Eindhoven (NL); JANSSEN, Bart Jozef, 5651GG Eindhoven (NL)
(74) Representative: Boult Wade Tennant LLP

(57) **Abstract**

A method of three-dimensional (3D) tomography comprising: providing a sample comprising an elongate section, the elongation of which defines an elongation axis having an axis length; acquiring a plurality of two-dimensional (2D) composite images of the elongate section along its axis length, each 2D composite image being generated from a respective series of image frames and comprising a projection of the elongate section that is parallel to the elongation axis, wherein each 2D composite image is acquired at a different respective angle of rotation of the sample, relative to an initial orientation of the sample, about a rotation axis that is substantially coincident with the elongation axis; and combining the plurality of projection images to obtain a 3D tomographic representation of the elongate section of the sample.

## Description

### Field of the Invention

The present invention relates to three-dimensional tomographic analyses of samples.

### Background of the Invention

Tomography is a set of imaging techniques that involves taking numerous images of an object with energy that penetrates the object's interior and then using the images of the object to produce a three-dimensional reconstruction of the object with one or more reconstruction algorithms, such as filtered back projection or iterative reconstruction. Tomography examples include magnetic resonance imaging, CT scanning, and ultrasound tomography, but many other techniques and radiative energy sources exist. Electron-based tomography, such as electron tomography or cryogenic electron tomography are also tomographic approaches and are generally applicable to tomographic imaging of small samples, e.g., from microns to the atomic scale, given the shorter wavelength of the imaging particles.

Transmission Electron Microscopy (TEM) tomography on needle-shaped samples (instead of the common slab-shaped samples) is becoming increasingly popular, primarily due to new tools to quickly fabricate such samples (e.g., by cryogenic focused-ion-beam milling). Using presently available technology, it is possible to tilt a needle-shaped sample to any angle between -90 and +90 degrees about its elongate axis, thereby advantageously eliminating the so-called missing-wedge problem. Often one wants to obtain 3D volume information of an elongated part of the needle. More generally, with regard to a sample of any shape, one may wish to enlarge the sample volume from which TEM image data is collected. Currently, this is achieved either by acquiring several tilt series of image acquisitions, or else by helical tomography which includes tilting while also shifting along the needle (if the sample is so shaped) to obtain a helical trajectory. The resulting images are subsequently reconstructed and stitched (or vice versa).

In an electron microscope, such as a Transmission Electron Microscope (TEM) an electron source produces a beam of energetic electrons with a selectable energy of, for example, between 80-300 keV, although higher and lower energies are known to be used. This beam is manipulated (focused, deflected) by optical elements (electron lenses, deflectors, multipoles) and irradiates a sample placed in a sample holder. The sample holder positions the sample, the holder typically showing three translational degrees of freedom (x, y, z) and one rotational degree of freedom (α) or more rotational degrees of freedom. The sample is generally sufficiently thin to be transparent to electrons. Although some electrons are absorbed, many electrons pass into and through the sample, either scattered or unscattered. Typically, the thickness of the sample is between 50 nm and 1 µm for biological samples (50-200 nm for cryogenic samples), and less than 100 nm for semiconductor samples. Another set of optical elements form an enlarged image of the sample on a detector, such as a CMOS camera, a CCD camera, a fluorescent screen, or a combination of fluorescent screen and camera connected via fiber optics. The image formed on the detector is a two-dimensional (2D) projection of the sample.

To achieve a three-dimensional (3D) image, a so-called tilt-series of projection images are first acquired. Tomographic imaging electron microscopy is based on acquisition of sample images at a plurality of angles of exposure. These angles are typically set by stepping an angular orientation of the sample through series of ascending angles, where the axis of rotation is essentially coincident with the long direction of the needle. In other examples, the angles are set by tilting the sample back and forth. One difficulty with these conventional approaches is the limited range of tilt angles. To achieve a 3D image, a series of images of the sample under different rotational orientations is acquired as a tilt-series. Typically, the tilt series covers a tilt range from -70 to +70 degrees with regular intervals of 1 or 2 degrees. The images of the tilt series are then aligned with respect to each other, and a 3D reconstruction is made using appropriate software, after which visualization may take place.

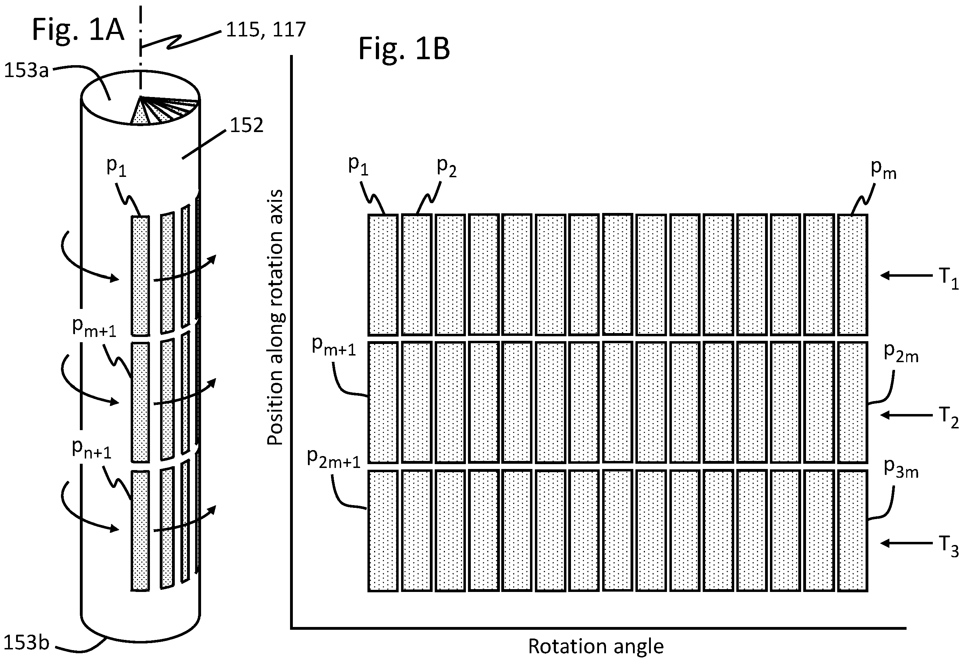

As an example of a conventional tilt series of image acquisitions, Figs. 1A and 1B schematically illustrate the angular orientation and positioning of three different tilt series of electron microscope images of an elongate sample (not shown) that is assumed to be aligned essentially parallel to and coincident with an axis 117 of a hypothetical cylinder 152 that has a first end 153a and a second end 153b. The first, second and third series of tilt images are schematically depicted by the three sets of image frames represented by the sets of shaded boxes labeled: p₁ through pₘ; pₘ₊₁ through p₂ₘ; and p₂ₘ₊₁ through p₃ₘ, respectively. Each such shaded box in Fig. 1A represents the intersection of an incident charged particle beam, such as an electron beam of a transmission electron microscope, with the hypothetical cylinder 152 that surrounds the sample at the axis 117 during the acquisition of a single image of the sample. In Fig. 1B, the shaded boxes are schematically depicted as if the surface of the cylinder 152 is flattened onto a plane, with the horizontal axis of Fig. 1B representing the rotation angle and the vertical axis representing position measured along the length of the cylinder 152 (i.e., measured parallel to the rotation axis).

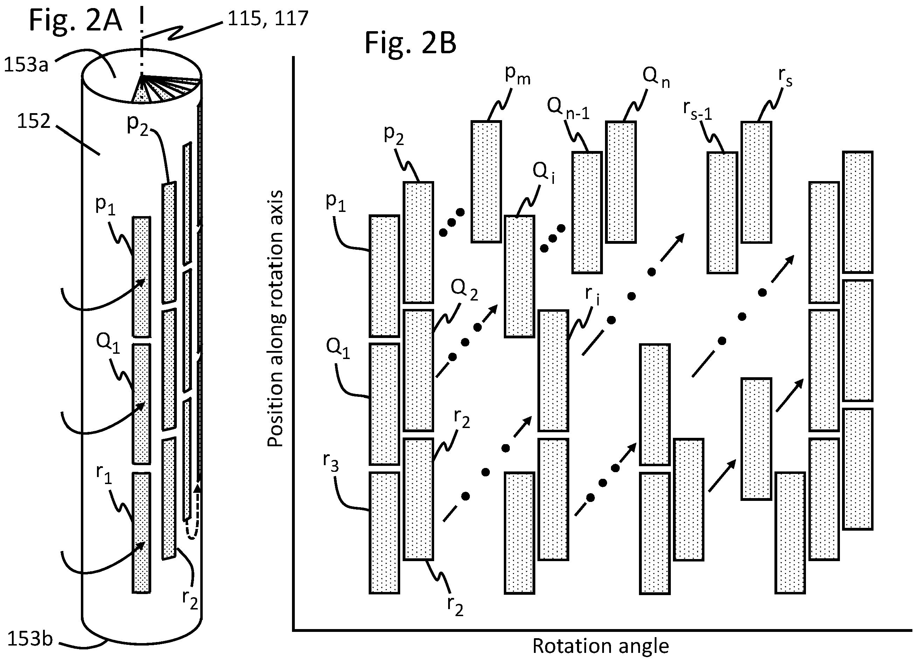

During acquisition of the various image frames that are depicted in Figs. 1A and 1B, it is assumed that the sample is rotated unidirectionally in a clockwise direction (as viewed looking towards first end 153a from above) about the axis 117 and that the enclosing cylinder 152 may be assumed as rotating with the sample. Under these conditions, the rotation causes the image frames to be acquired in the sequences represented by the arrows surrounding the cylinder. After acquisition of a first tilt series of images, represented by shaded boxes p₁ through pₘ, either the sample and/or the charged particle beam are translated in a direction parallel to the axis 117 in preparation for acquisition a second tilt series of images, represented by shaded boxes pₘ₊₁ through p₂ₘ. As schematically depicted in Figs. 2A and 2B, it is assumed (according to this example) that the images of the second series are acquired at the same angles of sample rotation and in the same order as the images of the first series.

Helical tomography generally involves taking numerous images of a sample in a helical manner, i.e., at numerous angles or projection locations around a sample, and using those images to form a 3D reconstruction of the sample. Figs. 2A-2B illustrate an example of a group of image acquisitions as may be obtained during a helical tomography procedure. The shaded boxes that are depicted in Fig. 2A are analogous to the shaded boxes shown in Fig. 1A in that each such shaded box represents the intersection of an incident charged particle beam, such as an electron beam of a transmission electron microscope, with a hypothetical cylinder 152 that surrounds the sample at the axis 117 of the cylinder during the acquisition of a single image of a portion of the sample. In similarity to the depiction of Fig. 1B, the shaded boxes are schematically depicted in Fig. 2B as if the surface of the cylinder 152 is flattened onto a plane. The image acquisitions of the helical tomography procedure comprise a plurality of series of image acquisitions (for example, series p, series Q and series r) in which, during each such series of image acquisitions, the sample is progressively rotated about the elongation axis 117 (which is assumed in this example to be essentially coincident with an apparatus rotation axis 115) such that each image of the series is obtained at a different respective rotation angle. For example, the series p comprises the set {P} of image acquisitions corresponding to the shaded boxes p₁, P₂, ··· , p*ᵢ*, ··· , p_{*m*-1}, P*ₘ*. Likewise, the series Q comprises the set {Q} of image acquisitions corresponding to the shaded boxes Q₁, Q₂, ··· , Q*ᵢ*, ··· , Q_{*n*-1}, Q*ₙ*. Likewise, the series r comprises the set {r} of image acquisitions corresponding to the shaded boxes r₁, r₂, ··· , r*ᵢ,* ··· , r_{*s-*1}, r*ₛ*. . Although three such series are depicted in Fig. 2A and a total of six such series (three of which are unlabeled) are depicted in Fig. 2B, any number of similar series of images may be acquired during a single imaging procedure. The values of m, n and *s* may or may not be equal to one another.

By comparison of Figs. 2A-2B to Figs. 1A-1B, it may be observed that the series p, Q, and r, ..., of image acquisitions (Figs. 2A-2B) are similar to the tilt series T₁, T₂, T₃, ··· of image acquisitions (Fig. 1B). However, whereas there is essentially no translational movement, parallel to the elongation axis 117, of the sample relative to the incident beam between successive image acquisitions during acquisition of a tilt series, there is an intentional translation of the sample relative to the incident beam between successive image acquisitions of the series p, the series Q the series r, etc., during a helical tomography procedure.

Although such conventional tomographic methods - e.g., tilt series tomography and helical tomography - have been successfully employed, there remain several challenges that may affect image quality and image-reconstruction efficiency. For example, when using either normal stitching of images or helical tomography, it is difficult to ensure that all areas of the sample receive equal quantities of electrons, which is important, in the case of radiation-sensitive samples, to prevent image artefacts or loss of resolution. Secondly, it is known that the procedure of stitching separate 3D reconstructed volumes or separate tilt series is a notoriously difficult mathematical problem. Thirdly, imaging procedures in which sample tilt or rotation steps are taken discretely - such as in normal tilt series or helical image acquisitions - necessitate substantial positional stabilization time intervals between each tilt or rotation step. Additionally, the quality of helical tomography three-dimensional structural reconstructions can be generally poor or variable and the helical tomography procedure can be associated with numerous difficulties, given the required precision and technical requirements. For example, positional drift of a sample after performing a movement of the sample during the image acquisition process can result in blurred images. Thus, a need remains for improvements to electron-based tomographic approaches.

US Patent No. 8,912,491, in the names of inventors Schoenmakers et al., discloses methods of performing tomographic imaging of a sample comprising providing a beam of charged particles; providing the sample on a sample holder that can be tilted; in an imaging step, directing the beam through the sample to image the sample; repeating this procedure at each of a series of sample tilts to acquire a set of images; in a reconstruction step, mathematically processing images from said set to construct a composite image, whereby in the imaging step, for a given sample tilt, a sequence of component images is captured at a corresponding sequence of focus settings; and in said reconstruction step, for at least one member of the series of sample tilts, multiple members of the sequence of component images are used in the mathematical image processing. Such methods render a 3D imaging cube rather than a 2D imaging sheet at a given sample tilt.

US Patent No. 7,884,326, in the names of inventors van de Water et al., discloses a manipulator for use in e.g., a Transmission Electron Microscope (TEM), said manipulator capable of rotating and translating a sample holder. The manipulator clasps the round sample holder between two members that are mounted on actuators. Moving the actuators in the same direction results in a translation of the sample holder, while moving the actuators in opposite directions results in a rotation of the sample holder.

US Patent No. 9,147,551, in the names of inventors Luecken et al., discloses a sample holder that can retain a sample and that can continuously rotate the sample in a single direction while the sample is exposed to a charged particle beam or other radiation source. The sample holder can rotate more than one complete revolution of the sample. The charged particle beam images are used in tomographic reconstruction, and in some cases, relative rotation angles are used in the reconstruction, without input of an absolute rotation angle. The method of tomography that relies on such continuous rotation of a sample in a single direction during exposure of the sample to a charged particle beam or other radiation source is referred to as "continuous tilt tomography".

US Patent No. 8,854,430, in the names of inventors Varslot et al., discloses methods for processing image data of a sample, the methods comprising: registering a first image and a second image of at least partially overlapping spatial regions of the sample and processing data from the registered images to obtain integrated image data comprising information about the sample, said information being additional to that available from said first and second images.

US Patent No. 10,254,419, in the names of inventors Kingston et al., method of investigating a specimen using a tomographic imaging apparatus using a stage for producing relative motion of a source with respect to a specimen, so as to allow the source and a detector to image the specimen along a series of different viewing axes and a processing apparatus for assembling a tomographic image of at least part of the specimen. The investigation is carried out by considering a virtual reference surface that surrounds the specimen and is substantially centered thereon, considering an incoming point of intersection of each of said viewing axes with this reference surface, thereby generating a set of such intersection points corresponding to the series of viewing axes, and choosing discrete viewing axes in the series so as to cause the set to comprise a two-dimensional lattice of points located areally on the reference surface in a substantially uniform distribution.

US Patent No. 9,618,460, in the names of inventors Schoenmakers et al., discloses a method of performing tomographic imaging involving repeatedly directing a charged particle beam through a sample for a series of sample tilts to acquire a corresponding set of images and mathematically combining the images to construct a composite image, wherein the mathematical combining consists of, at each of a second series of sample tilts, using a spectral detector to accrue a spectral map of said sample, thus acquiring a collection of spectral maps; analyzing said spectral maps to derive compositional data of the sample; and employing said compositional data in constructing said composite image.

US Patent No. 10,937,625, in the names of inventors Franken et al., discloses methods of imaging a sample, where said sample is mounted on a sample holder in an electron microscope, the electron microscope comprising an electron source for generating a beam of energetic electrons along an optical axis and optical elements for focusing and deflecting the beam so as to irradiate the sample with a beam of electrons. The sample holder is capable of positioning and tilting the sample with respect to the electron beam. The method comprises the step of acquiring a tilt series of images by irradiating the sample with the beam of electrons, and concurrently changing a position of the sample during acquisition of the images, so that each image is acquired at an associated unique tilt angle and an associated unique position. In an embodiment, use is made of "stroboscopic illumination" of the sample. The sample is illuminated in a stroboscopic manner, and the frequency of the illumination pulses may be synchronized with camera frame read-out.

US Patent No. 11,257,656, in the names of inventors Janssen et al., discloses a rotating sample holder for random angle sampling in tomography. The sample holder retains a sample and can continuously rotate the sample in a single direction while the sample is exposed to a charged particle beam or other radiation source. Typically, the charged particle beam is strobed to produce a series of charged particle beam images at random or arbitrary angles of rotation. The sample holder can rotate more than one complete revolution of the sample. The charged particle beam images are used in tomographic reconstruction, and in some cases, relative rotation angles are used in the reconstruction, without input of an absolute rotation angle

Pre-Grant Publication No. 2022/0310354-A1 methods, as well as relates systems and apparatuses, that include or provide for holding a sample with a movement stage configured to rotate the sample about a rotation axis, directing an imaging beam to a first sample location with the sample at a first rotational position about the rotation axis and detecting a first US transmitted imaging beam image, rotating the sample using the movement stage about the rotation axis to a second rotational position, and directing the imaging beam to a second sample location by deflecting the imaging beam in relation to an optical axis of the imaging beam and detecting a second transmitted imaging beam image, wherein the second sample location is spaced apart from the first sample location at least at least in relation to the optical axis. Some examples further include directing the imaging beam to one or more additional sample locations at one or more additional rotational positions and detecting corresponding transmitted imaging beam images, wherein the first sample location at the first rotational position, the second sample location at the second rotational position, and the one or more additional sample locations at the one or more additional rotational positions comprise an imaging beam helical imaging trajectory for the sample.

### Summary of the Invention

Disclosed herein are novel alternative methodologies for three-dimensional tomographic imaging of either needle-shaped samples or elongated portions of slab-shaped samples. These novel methods are characterized by the following features:
- Each unique sample tilt within a tilt range of interest is visited only once and, at each tilt angle, either a plurality of image frames or a single camera acquisition in "movie mode" is/are obtained across the length of a feature of interest, while simultaneously translating the sample relative to an incident beam parallel to the elongate axis of sample or sample portion. The translation may be performed either continuously and smoothly or, alternatively, in well-defined discrete steps. The translational movement may be produced either using optics adjustments (e.g., using beam deflectors to adjust the imaged part of the sample), sample stage motion using x, y actuators or a combination of both.
- Optionally, stroboscopic imaging or coded exposure imaging (a technique known from optical photography) is used to enhance high-frequency spatial information and thereby reduce or eliminate motion blur. According to one method of stroboscopic imaging, an incident beam may be periodically or otherwise intermittently introduced onto the sample as a result of repeated beam blanking. According to a second method of stroboscopic imaging, the image beam may be periodically or otherwise intermittently interrupted by blanking the beam between the sample and a detector (e.g., a camera). Such forms of stroboscopic imaging may be effective in reducing motion blur and may be employed in certain embodiments. However, stroboscopic imaging can severely limit the achievable dose rate of charged particles at the camera, thereby leading to poor image quality, as the beam will be blanked most of the time. Coded exposure imaging, which makes use of either method of stroboscopic imaging noted above, provides an alternative that permits more-efficient use of an available "dose budget" by using a (pseudo)random beam blanking timing pattern. The resulting data can be deconvolved reliably to recover spatial information from blurred images.

- Optionally, the tilt and/or curvature of the sample may be tracked in near real-time by analysis of the needle center position in the movie frames or in the plurality of still images. This information may be used to provide near real time correction of the direction of beam translation or stage movement as well as correction of beam focus. The focus correction may be accomplished by either stage movement parallel to the z-axis (i.e., the direction of the incident beam) or by objective lens adjustments. This optional tracking feature is important in case the needle is mounted with a nonzero angle with respect to the tilt axis or when the sample is either broken or bent significantly compared to either the size of the field of view or the maximum acceptable change in focus.
- Optionally, for each tilt angle, the direction of movement of the sample relative to the incident beam may alternate between forward and backward movement along the length of the sample, to further minimize necessary movement during image acquisitions.
- After (or during) acquisition of a plurality of images at each tilt angle, a two-dimensional elongate projected image of the sample is constructed using the data of the acquired images at the respective tilt angle. The resulting set of two-dimensional images - each corresponding to a different respective tilt angle - are used as input to one or more three-dimensional tomographic reconstruction of the structure of the sample, which may be performed by known techniques. In some instances, for example, complete or partial 3D reconstructions may be obtained at the same time that additional image frames are being acquired. In some instances, construction of two-dimensional composite images may alternate with 3D tomographic reconstructions.

According to a first aspect of the present teachings, a method of three-dimensional (3D) tomography is provided, the method comprising: (a) providing a sample comprising an elongate section, the elongation of which defines an elongation axis having an axis length; (b) acquiring a plurality of two-dimensional (2D) composite images of the elongate section along its axis length, each image corresponding to a projection of the elongate section that is parallel to the elongation axis, wherein each image is acquired at a different respective angle of rotation of the sample, relative to an initial orientation of the sample, about a rotation axis that is substantially coincident with the elongation axis; and (c) combining the plurality of projection images to obtain a 3D tomographic representation of the elongate section of the sample.

In various embodiments of the method, each acquisition of a 2D image of the elongate section across its length comprises acquiring a series of image frames, all images of the series corresponding to the same angle of rotation of the sample about the rotation axis, relative to the initial orientation, each image frame corresponding to a 2D projection image of the elongate section along a portion of the length of the 2D projection image. Each such image frame of each series may overlap at least one other adjacent image frame of the same series. In such instances, overlapping portions of the image frames may be used to align the frames in preparation for generating the corresponding 2D projection image from the image frames. Alternatively, there may be no overlap of image frames within each series and, in such instances, each 2D image of the elongate section across its length may be generated from the non-overlapping image frames of the corresponding series of image frames by digital reconstruction of sample features between adjacent frames. As an additional alternative, in the case of very accurate image positioning, there may be no image overlap but also no lack of coverage between successive images. In such situations, stitching to create 2D composite images is trivial.

In various embodiments of the method, the acquiring of each 2D image comprises acquiring at least one transmission electron microscope (TEM) image. The thickness of the elongate section, taken perpendicular to the elongation axis, may be less than or equal to one micrometer (µm). In various embodiments, the acquiring of each 2D image may comprise acquiring at least one image of the emission of photons from the sample in response to impingement of charged particles onto the sample. In various embodiments, the providing of the elongate section of the sample may comprise creating the elongate section by ion beam milling of the sample. In various embodiments, the plurality of angles of rotation of the sample, relative to the initial orientation of the sample, may range between ninety degrees and negative ninety degrees.

In various embodiments of the method, the acquiring of each series of image frames may comprise varying, between acquisitions of successive image frames, a position of the sample relative to an incident flux of photons, electrons or ions that are directed onto the sample. The varying of the position of the sample relative to the incident flux may comprise either varying a position of the sample, varying a position of the incident flux or simultaneously varying both the position of the sample and the incident flux. The direction of the relative movement may be reversed after the acquiring of each 2D image. In various embodiments, the relative positions of the sample and the incident flux may be continuously varied during the acquiring of each series of image frames. During such continuous position variation, the incident flux may be pulsed, whereby each image frame of each series of image frames corresponds to a respective pulse. In various embodiments, the timing of the pulses of the incident flux may be in accordance with a pre-generated pseudo-random sequence.

In variations, the method may further comprise: (d) detecting, based on at least one of the 2D images, a second elongate section of the sample, the elongation of the second elongate section defining a second elongation axis having a second axis length; (e) acquiring a plurality of 2D images of the second elongate section along the second axis length, each image corresponding to a projection of the second elongate section that is parallel to the second elongation axis, wherein each image is acquired at a different respective angle of rotation of the sample, relative to an initial orientation of the sample, about a second rotation axis that is substantially coincident with the second elongation axis; and (f) combining the plurality of projection images of the second elongate section to obtain a 3D tomographic representation of the second elongate section of the sample.

According to a second aspect of the present teachings, a charged particle beam apparatus is disclosed, wherein the apparatus comprises: (a) a source of charged particles; (b) a charged particle beam column configured to direct a beam of charged particles from the source of charged particles onto an elongate portion of a sample mounted on a rotatable and translatable sample stage; (c) charged particle beam optics or photonic optics configured to transfer, to a detector, either charged particles or photons either transmitted through or generated at the sample in response to the impingement of the beam of charged particles onto the sample, wherein the transfer of the charged particles or photons comprises generation of an image frame that comprises a projection of the elongate section along a portion of its length; and (d) a controller environment electrically coupled to one or more of the source of charged particles, the rotatable and translatable sample stage, the charged particle beam optics or photonic optics and the detector, the controller environment comprising program instructions that are operable and configured to execute any of the method embodiments disclosed herein.

According to a third aspect of the present teachings, there is disclosed a computer program product comprising program instructions that, when executed on a controller environment of a three-dimensional tomographic imaging system, are operable to execute the method embodiments that are disclosed herein.

### Brief Description of the Drawings

In order to best understand the features and advantages of the teachings of this disclosure, the reader is referred to the appended drawings, which are to be viewed in conjunction with the detailed description of certain examples provided below. Understanding that these drawings depict only exemplary embodiments of the invention and are not therefore to be considered to be limiting in scope, the examples will be described and explained with reference to the accompanying drawings in which:
Figs. 1A and 1B are schematic depictions of sequences of image acquisitions as may be employed during the practice of conventional tilt-series tomographic analysis;
Figs. 2A and 2B are schematic depictions of sequences of image acquisitions as may be employed during the practice of conventional helical tomographic analysis;
Fig. 3 is a schematic depiction of an exemplary charged particle microscope imaging system as may be employed to perform methods in accordance with the present teachings;
Figs. 4A and 4B are schematic depictions of sequences of image acquisitions as may be employed during the practice of three-dimensional tomographic analyses in accordance with the present teachings; and
Fig. 5 is a schematic depiction of the acquisition, in accordance with the present teachings, of a sequence of overlapping image frames across the length of an elongate sample in preparation for construction of an elongate composite image from the image frames;
Fig. 6A is another schematic depiction of the acquisition, in accordance with the present teachings, of a sequence of overlapping image frames across the length of an elongate sample in preparation for construction of an elongate composite image from the image frames;
Fig. 6B is a schematic depiction of a first method of acquisition of multiple images along a length of an elongate sample whereby a series of short pulses of a charged particle beam are incident onto the sample as the sample continuously moves through the field of view of a charged-particle-beam imaging system;
Fig. 6C is a schematic depiction of a second method of acquisition of multiple images along a length of an elongate sample wherein the sample is maintained stationary with respect to an incident charged particle beam during each image acquisition and either the sample and/or the charged particle beam are moved relative to one another between acquisitions;
Fig. 6D is a schematic comparison between imaging using a traditional single exposure of an object and imaging using coded exposure of a moving object;
Fig. 7 is a depiction of a hypothetical, generally-elongate, needle-like sample that does not conform to a single axis of elongation.
Fig. 8 is a flow diagram of a first exemplary method of three-dimensional tomographic analysis in accordance with the present teachings; and
Fig. 9 is a flow diagram of a second exemplary method of three-dimensional tomographic analysis in accordance with the present teachings

### Detailed Description of the Invention

Typically, during inspection and/or analysis of a sample by charged particle tomography, a sample may be situated on a rotatable sample stage of a charged particle microscope for repetitive exposure to a charged particle beam (CPB). As used herein, the term "charged particle" encompasses an electron or ion (generally a positive ion, such as a Gallium ion or Helium ion, for example, though a negative ion is also possible). It may also be a proton, for example. The term "charged-particle microscope" refers to an apparatus that uses a charged-particle beam to create a magnified image of an object, feature or component that is generally too small to be seen in satisfactory detail with the naked human eye. In addition to having an imaging functionality, such an apparatus may also have a machining functionality; for example, it may be used to locally modify a sample by removing material therefrom ("milling" or "ablation") or adding material thereto ("deposition"). Said imaging functionality and machining functionality may be provided by the same type of charged particle, or may be provided by different types of charged particle; for example, a Focused Ion Beam (FIB) microscope may employ a (focused) ion beam for machining purposes and an electron beam for imaging purposes (a so-called "dual beam" microscope), or it may perform machining with a relatively high-energy ion beam and perform imaging with a relatively low-energy ion beam.

The tomography examples disclosed herein are generally described with reference to transmission electron microscopy, but other CPBs can be used. As used herein, "column" refers generally to one or more CPB optical elements or combinations of elements such as CPB sources, CPB lenses, CPB deflectors, CPB apertures, stigmators, or other CPB optical elements. Such optical elements can be used to produce a pulsed CPB that can be directed to a sample to provide a pulsed exposure. Such pulsed exposures are generally referred to as "stroboscopic" exposures to indicate that effective exposure times are sufficiently short, in comparison to the time required to rotate or translate a sample by a detectable amount, to enable acquisition of suitable images, i.e., images without undue motion-induced blurring. In some of the disclosed examples, a CPB or a CPB column may be energized to produce a stroboscopic CPB exposure. The term "sample holder" refers to any type of table, platform, arm, etc., upon which a sample can be mounted and held in place. Generally, such a sample holder will be comprised in a sample holder stage assembly, with which it can be accurately positioned in several degrees of freedom, e.g., with the aid of electrical actuators.

As used in the following description as well as in the claims, the singular forms "a," "an," and "the" include the plural forms unless the context clearly dictates otherwise. Additionally, the term "includes" means "comprises." As used herein, the term "essentially", when used to indicate that a certain object, system, variable, or parameter "essentially" has, is, comprises, or equals a particular shape, size, orientation, value, or other property means that the referenced certain object, system, variable, or parameter either has, is, comprises, or equals, *within a normal range of experimental error,* the stated particular shape, size, orientation, value, or other property. In this sense, the normal experimental error is taken as a customary and generally accepted error value, as known by those of normal skill in the art, that depends upon the identity and technological complexity of the referenced certain object, system, variable or parameter. As used herein, the term "substantially", when used to indicate that a certain object, system, variable, or parameter "substantially" has, is, comprises, or equals a particular shape, size, orientation, value, or other property means that the referenced certain object, system, variable, or parameter intentionally only approximates or is an approximation of or to the stated particular shape, size, orientation value or other property.

The systems, apparatus, and methods described herein should not be construed as limiting in any way. Instead, the present disclosure is directed toward all novel and non-obvious features and aspects of the various disclosed embodiments, alone and in various combinations and sub-combinations with one another.

Although the operations of some of methods that are disclosed herein are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "generate" and "provide" to describe the disclosed methods. These terms are high-level abstractions of the actual operations that are performed. The actual operations that correspond to these terms will vary depending on the particular implementation and are readily discernible by one of ordinary skill in the art.

The term "image" is used herein to refer to a displayed image such as on a computer monitor, or digital or analog representations that can be used to produce displayed images. Digital representations can be stored in a variety of formats such as JPEG, TIFF, Medical Research Council (MRC), Electron-Event Representation (EER), or other formats. Image signals can be produced using an array detector or a single element detector along with suitable scanning of a sample. In most practical examples, images are two-dimensional. As used herein, the term "image" also encompasses the terms "image frame" and "composite image", and the plurals thereof. In other words, an "image frame" is also an "image" and may be referred to as such. Likewise, a "composite image" is also an "image" and may be referred to as such. In specific use herein, an "image frame" is an image that is acquired from a portion that of a sample that is smaller than a region of interest as a result of exposure to that sample portion to either photons or charged particles (e.g., electrons or ions). In contrast, a "composite image", as that term is used herein, is an image that is derived by combination of the information of two or more image frames and that pertains to a sample volume or a sample area that is greater than the sample area or sample volume that is imaged by any one of the individual image frames from which it is derived.

Thus, as the terms are used herein, a composite image comprises data from more than one image frame. The areal extent of the sample that is imaged by any individual such image frame may or may not overlap the areal extent of the sample that is imaged by any other such image frame.

Sample stage rotations and translations as discussed herein can be provided with motors and actuators of various kind, including DC motors, stepper motors, rotary piezoelectric motors, AC motors, or other devices. Rotation angles and translational movement distances can be detected with optical encoders, magnetic encoders or other devices. The terms "continuous rotation" and "continuous translation" refer to rotations and translations that are allowed to proceed, without stoppage, during image acquisition. For example, sequences of drive signals applied to a stepper motor to produce a rotation or translational movement can continue during image acquisition and a waiting time at a selected imaging angle or position is not needed. Although a stepper motor is used, the rotation is referred to as continuous. In other examples, a continuous (i.e., non-stepper) motor may be allowed to freely rotate or translate the sample. Images can be acquired at random times.

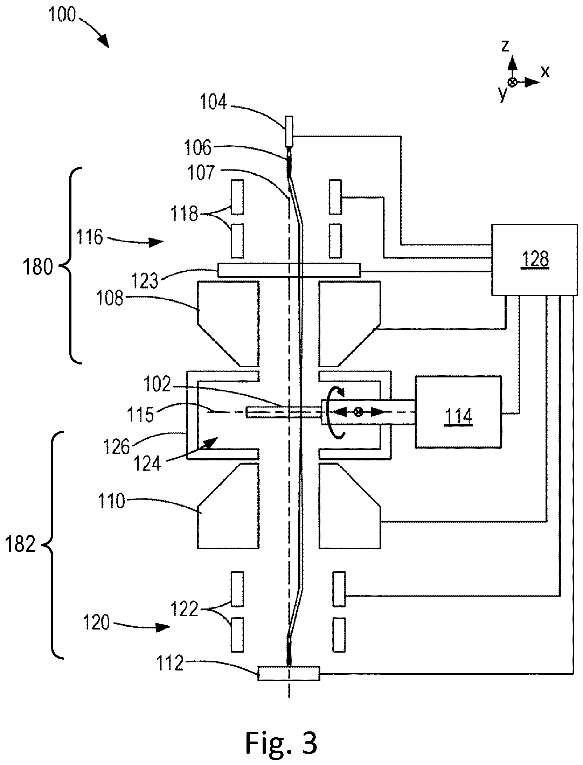

Fig. 3 shows an exemplary charged particle microscope imaging system 100 as may be employed to execute the methods of the present teachings, specifically, a transmission electron microscope. The sample 102 can have various shapes and cross-sections. However, for the purpose of this discussion, it is assumed that the sample comprises at least one section that has an elongate shape, such as a needle-shape or an elongate slab shape. The imaging system 100 includes an electron beam source 104 configured to produce a beam 106 along an optical axis 107 (an axis generally aligned with the apparatus z-direction as shown in the figure). The imaging system 100 also includes electron optics of a charged particle beam column 180, such as one or more objective lens elements 108, 110 configured to direct the beam 106, onto and through the sample 102. The beam 106 is typically received by an electron imaging detector 112 after transmission through the sample 102 so as to provide an image of the sample 102 at a particular orientation. Suitable electron detectors can include direct and indirect detectors or sensors, including CCD, CMOS, pixel arrays, photomultiplier tubes, etc. The beam 106 can be focused and/or collimated one or more times before it is received by the detector 112, including at or near the sample.

Still with reference to Fig. 3, the particular orientation of the sample 102 is provided by a movement stage 114 configured to hold and vary the orientation of the sample 102 by rotation about an axis 115 (shown aligned with the x-direction in the figure) and translation along one or more axes (e.g., x, y, and z). Thus, the movement stage 114 comprises both a translation stage component and a rotation stage component. The movement stage 114 can be configured to move and position the sample, such as at a central or offset position, or to compensate for a drift. In further examples, the beam source 104 can include other energy sources such as x-ray, ultrasound, etc., the optics can be configured to direct imaging beams other than electrons, and the detector 112 can be configured to detect imaging beams other than electrons (e.g., X-ray photons).

The imaging system 100 further includes an image deflector 120 configured to direct an image beam 106, after having passed through a portion of a sample 102 that is offset from the optical axis 107, onto the imaging detector 112. An optional beam deflector 116 may be configured to direct the beam 106, prior to its impingement on a sample 102, away from the axis 107 so that the beam 106 impinges on the sample at a translated position relative to the intersection of the axis 107 and sample 102, e.g., along the x direction or both the x and y directions. In the illustrative depiction in FIG. 3, the beam 106 is shown translated in the x-direction by the optional beam deflector 116. In some examples, the beam deflector 116 includes beam deflection coils 118, such as magnetic or electrostatic coils, DC coils, AC coils, fast-scan coils, etc. The image deflector 120, is equipped with coils 122 that are similar to the coils 118. The coils 122 may be used to deflect the beam 106 back towards the optical axis 107. By operating the image deflector 120 in conjunction with either motion of the movement stage 114 and/or operation of the beam deflector 116 (if present), various imaging sequences can be efficiently collected, e.g., forming helical trajectories, as well as additional or other trajectories or shapes, including double helical, circular, serpentine, saddle, 2D lattice of points, 3D lattices, etc., in tomographic as well as other applications. Examples of the imaging system 100 can also include a beam blanking unit 123 configured to block the beam for selected durations, such as between imaging times or during beam deflection or stage movement.

Various components of the imaging system 100 can be coupled to a controller environment 128 configured with one or more controllers, computing devices, processors, memory, and/or other components to coordinate directing the beam 106 to the sample 102, orientation and movement of the sample 102 by the movement stage 114, and deflection of the beam 106 with the beam deflector 116. The controller environment 128 can also be configured to control the lens elements 108, 110, emission of the beam 104, blanking with the beam blanker 123, temperature and/or pressure of the cryogenic volume 124, and signal timing and/or synchronization of the detector 112 with either movements (i.e., rotations and translations) of the sample, beam blanking or pulsing and/or image data acquisitions. The control environment 128 may be configured with computer readable instructions that automatically cause the various components of the imaging system 100 to operate in a coordinated manner so as to execute the novel tomography methods that are disclosed in this document.

Control components of the controller environment 128 can include desktop or laptop computers, mobile devices, tablets, logic controllers, etc. Processors can include CPUs, GPUs, ASICs, PLCs, FPGAs, PLDs, CPLDs, etc., that can perform various data processing or I/O functions associated with the controller environment 128, such as control and/or data processing. Memory can be volatile or non-volatile (e.g., RAM, ROM, flash, hard drive, optical disk, etc.), fixed or removable, and is coupled to the processor. The memory can provide storage capacity for one or more computer-readable media. The controller environment 128 can also be situated in a distributed form so that applications and tasks are performed by remote processing devices that are linked through a communications network. Program modules and logic can be located in both local and remote memory storage devices. In some examples, components in the controller environment 128 need not be linked with other components.

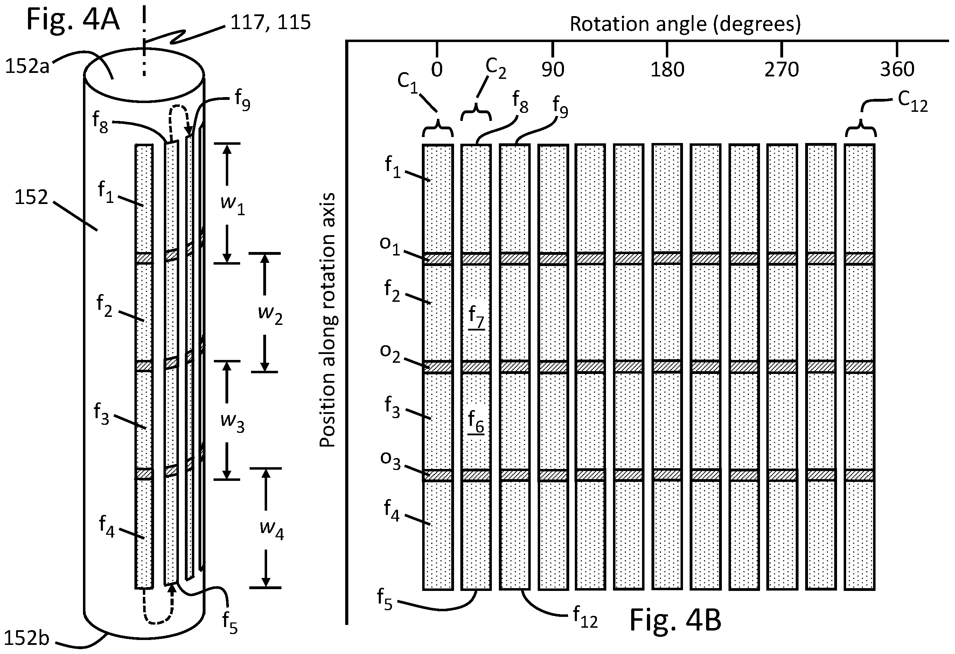

Figs. 4A-4B schematically illustrate a sequence of image acquisitions that may be performed in accordance with methods of 3D tomography described herein. The shaded boxes that are depicted in Fig. 4A are analogous to the shaded boxes shown in Figs. 1A and 2A in that each such shaded box pertains to the acquisition of a single image of a portion of the sample and represents the intersection of an incident charged particle beam with a hypothetical cylinder 152 that surrounds a sample (not shown) that is disposed, at least approximately, on an axis of rotation 115 of a sample holder, where the axis of rotation 115 is coincident with the cylinder axis 117. Whereas the axis of rotation is instrumentation-dependent, the cylinder axis 117 may be defined or chosen based on the particular geometry of the sample. The shaded boxes depicted in Fig. 4B are similar to the shaded boxes depict of Figs. 1B and 2B in that, for convenient viewing, they schematically represent the same shaded boxes as in Fig. 4A but with the surface of the cylinder 152 being flattened onto a plane.

Methods in accordance with the present teachings pertain to tomographic reconstruction of the structure of an elongate portion of a sample of which the direction or axis of elongation is approximately parallel to the axes 117, 115. Preferably, but not necessarily, the elongate portion of the sample comprises an axis of elongation 117 that is essentially parallel to and essentially coincident with the axis of rotation 115. Such conditions are essentially met if the elongate portion is itself cylindrical or approximately cylindrical (i.e., an elongate needle or pillar) or else comprises planes of symmetry whose intersections define the axis of symmetry (e.g., slab-shaped samples). Such sample shapes may be fabricated during pre-analysis sample preparation by ion-beam milling, for example. Nonetheless, actual elongate samples may comprise variations in thickness along their length or may comprise irregularly shaped surfaces, such as surfaces with various protrusions or pits, that do not fully conform to axial symmetry. In such instances, methods in accordance with the present teachings may include a step of either defining or choosing the elongation axis of a sample or of an elongate section of a sample as a line of maximum length through the sample or elongate section that may be may be made coincident with, aligned on, or parallel to the rotation axis 115. Further, actual needle-like or slab-shaped samples may not be perfectly straight and may, instead, comprise curves or bends. Methods for imaging such samples are described later in this document.

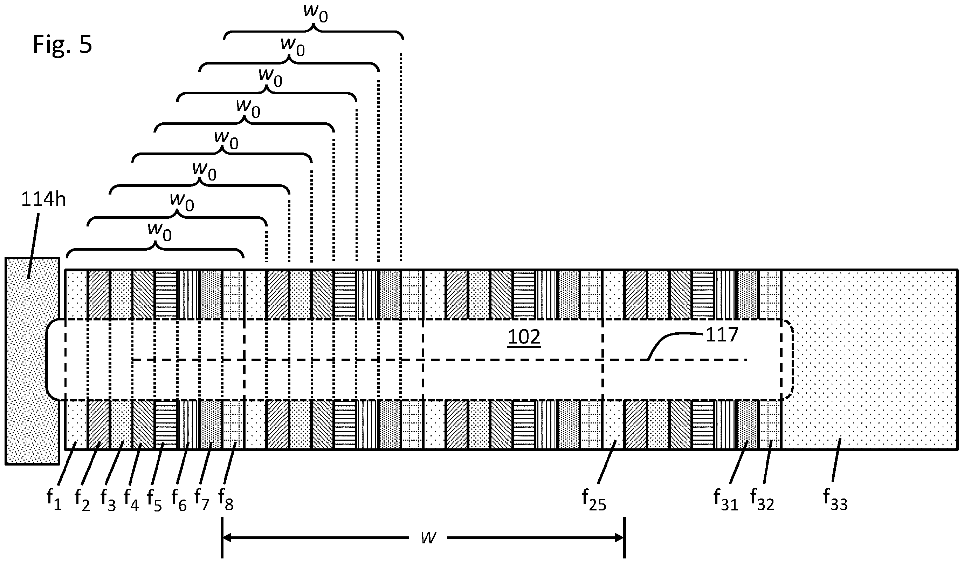

Returning to the discussion of Figs. 4A-4B, it should be noted that each shaded box represents acquisition of a single respective image frame. The first five acquired image frames are represented, in the sequence of their acquisition, by the shaded boxes f₁, f₂, f₃, f₄, and f₅. For purposes of example, it is assumed that only four such image frames (e.g., image frames f₁, f₂, f₃, and f₄) are required for imaging the full length, W, as measured parallel to the axis 115, of a region of interest of the sample. In Fig. 4A, this length, W, is indicated in a vertical orientation, solely for purposes of example. The lengths of the image frames, taken parallel to the axis 115, are denoted as *w*₁, *w*₂, *w*₃, and *w*₄. These image frame lengths may be equal to one another in many instances. Thus, as shown in Figs. 4A and 4B, *w*₁ = *w*₂ = *w*₃ = *w*₄. However, it is not necessary for the image frame lengths to all be equal to one another. For ease of depiction, the image frames are illustrated as being elongate parallel to the axes 115, 117 in the drawings. In practice, the image frame may not be elongate. For example, camera frames captured by TEM cameras may be square or nearly square (e.g., see FIG. 5).

As further shown in Figs. 4A-4B, successive frames may overlap one another. Such regions are indicated, in Fig. 4B, with dark shading, as overlap regions o₁, o₂, o₃, and o₄. For example, the overlap region, o₁, is formed by the overlap of image frame f₁ with image frame f₂. Likewise, the remaining overlaps depicted in Fig. 4B are regions at which an area imaged by a later image frame overlaps a portion of an area imaged by an earlier image frame. The overlapping regions permit recognition of common image features that may be used to properly align image frames, one to another, and to equalize the exposures of a set of images in preparation for generating a composite image from a plurality of image frames, as discussed further herein below.

As shown in Figs. 4A and 4B, the image frames f₁, f₂, f₃, and f₄ are all acquired without intervening rotations of a rotation stage; that is, the image frames f₁, f₂, f₃, and f₄ are all acquired at an initial angular setting of the rotation stage, which may be defined as zero degrees as denoted in Fig. 4B. This set of image frames, all obtained at a rotation stage setting of zero degrees, is labeled as image frame set C₁ in Fig. 4B. Each of these image frame acquisitions generates a projected image of a different respective portion of the elongate sample or elongate sample portion with some overlap between the different portions. Each image frame is acquired by directing a beam of charged particles onto a first side (e.g., the "top" side; see Fig. 3) of the portion of the sample 102 that is being imaged and detecting either charged particles and/or photons that emerge, in response to the impingement of the beam onto the sample, from the opposite side (e.g., the "bottom" side) of the portion of the sample.

To re-position the imaged location from one portion to another portion of the sample (for example, from image frame f₁ to image frame f₂) during acquisition of the image frame set C₁, either: (a) the incident beam is moved parallel to the rotation axis 115 in a first direction (e.g., towards the bottom of the drawing in Fig. 4A) from the location of image frame f₁ towards the intended location of image frame f₂; (b) the sample stage and the sample mounted thereon are translated, parallel to the rotation axis in a second direction that is opposite to the first direction (e.g., towards of the top of the drawing in Fig. 4A); or (c) a combination of a and b, i.e. the incident beam is moved in the first direction and the sample stage is moved in the second direction. The movement of the incident beam parallel to the rotation axis 115 may be controlled, as illustrated in Fig. 3, by adjusting voltages applied to electrodes of a beam deflection unit 118 and/or other electrodes of a charged particle beam column 180, this adjustment possibly supplemented by complementary adjustment of a descanning unit 122 and/or other electrodes of a sub-stage image transfer assembly 182. The translational movement of the sample stage may be controlled by actuators, such as piezoelectric actuators, as is known in the art.

After completion of acquisition of all image frames of the image frame set C₁, the rotation stage mechanism is operated so as to rotate the elongate sample or sample portion by a pre-determined angular increment, such as thirty degrees, as illustrated in Fig. 4B. Then with the rotation stage remaining fixed the angular setting of 30 degrees, a second set of image frames is acquired. As shown in Fig. 4B, the second set of acquired image frames is labeled as image frame set C₂, which, according to the example system, consists of image frames f₅ through f₈. In general, the various tilt angles may be visited in any order, depending on the requirements of an experiment. For example, some sequences of tilt angles may be preferred for purposes of minimizing the dosages of electrons that are received by certain portions of the sample. In some sequences, positive tilt angles may alternate with negative tilt angles, with the magnitude of the tilt angles increasing with time. An example of this type of sequence would be tilt angles (all in degrees) in the order 0, +3, -3, -6, +6, +9, -9, -12, +12, etc. Alternatively, a sequence of coarse tilt-angle increments (e.g., in 30-degree steps) may be followed by a refinement that employs sequence of smaller tilt angle increments (e.g., in 10-degree increments). By means of this latter technique, it is possible to obtain, relatively early in the imaging sequence when the total received electron dosage is still low, data using the tilt angles that provide the most informative structural information.

To re-position the imaged location from one portion to another portion of the sample (for example, from the location that corresponds to image frame f₅ towards the location that corresponds to image frame f₈) either the incident beam and/or the translation stage is moved parallel to the rotation axis 115 as described previously.

However, for efficiency of data collection, it may be the case that, during acquisition of the image frame set C₂, the direction of relative motion between the sample and the incident beam is opposite to the direction of relative motion utilized during acquisition of the image frame set C₁. This change of direction between image frame sets is indicated by the curved dashed arrows in Fig. 4A. According to such mode of operation, the image frames of C₂ are acquired, in order, from image frame f₅ to image frame f₈, all without any rotation of the rotation stage. After the acquisition of image frame f₈ of the image frame set C₂, the rotation stage mechanism is operated so as to rotate the elongate sample or sample portion to a new tilt angle. After the rotation, the image frames fg through f₁₂ of the next image frame set are acquired in order during translation of the incident beam and/or the translation stage. As noted above, the tilt angles may be visited in any suitable order. For example, the sample may be rotated by another pre-determined angular increment, which may be equal to the angular increment employed in the preceding rotation. Alternatively, the sample may be rotated in accordance with a specific tilt-angle sequence, as noted in the preceding paragraph, that is chosen either to minimize overall electron dosage or to utilize tilt angles that provide useful structural information early in the imaging sequence. Further, the direction of movement of the sample relative to the incident charged particle beam may be reversed, relative to the direction of movement during acquisition of an immediately preceding image frame set, for each next acquired image frame set. For example, such changes of relative movement are indicated by dashed arrows in Fig. 4A.

FIG. 5. According to the methods of the present teachings, some or all of the image frames of each image frame set (C₁, C₂, ..., Cⱼ, ..., C_{z}) are combined into a single respective composite image. Each such composite image represents a projection, corresponding to a single rotation angle, of a portion of an elongate region of the sample. For example, with reference to Fig. 4B, the image data of image frames f₁, f₂, f₃ and f₄ is combined into a first elongate composite image (not shown in Figs. 4A-4B) that is a projection of the features and/or structure of the sample as obtained at an angular rotation of the sample of zero degrees (i.e., as obtained at a reference orientation). Likewise, the image data of image frames f₅ through f₈ is combined into a second elongate composite image that is a projection of the features and/or structure of the sample as obtained at an angular rotation of the sample of thirty degrees relative to the reference angular rotation.

Preferably, but not necessarily, the movement of the sample relative to the incident charged particle beam during acquisition of an individual image frame set is such that at least one portion of the sample is imaged in more than one image frame. Stated differently, the relative movement is such that there is overlap between a first region of the sample that is imaged in a first image frame and a non-identical region of the sample that is imaged in a second image frame. For example, such overlapping regions are indicated, in Figs. 4A-4B, by darkly shaded regions; some of which are denoted as overlap regions o₁, o₂ and o₃. The overlapping regions are also indicated by the boundaries of the image frames, as indicated by the frame-length dimension markers that show image frame lengths *w*₁, *w*₂, *w*₃ and *w*₄. Such overlapping regions may be beneficial in aligning the image frames during subsequent reconstruction of a composite image. Alignment between images may oftentimes be needed in order to provide reconstructions of sufficient image quality. In general, alignment involves determining from which direction and from which position the images were acquired relative to the sample. Even with high quality movement stages, beam precision, and other high-quality instrumentation, Angstrom positioning resolution would be needed in order to obtain Angstrom resolution in a tomographic reconstruction; such level of movement precision is impractical. Thus, alignment may be needed, under certain circumstances, to determine where the acquired image projections belong and align together with the other image projections. In the case of very accurate image positioning, there may be no image overlap but also no gaps between successive images. In such situations, alignment may not be necessary.

Fig. 5 schematically depicts a more complex example of overlapping image frames. In Fig. 5, an elongate sample 102 is aligned parallel to axis 117 and is held by a sample holder 114h, which is a component of a movement stage assembly 114 (Fig. 3) having at least the capability of rotating the sample 102 about a rotation axis 115 that is substantially parallel to and substantially coincident with axis 117. The movement stage assembly may also have the capability of translating the sample at least along a direction of movement that is substantially parallel to axis 117. Also depicted in Fig. 5 are representations of thirty-three different image frames, denoted as image frames f₁ through f₃₃. For purely visualization purposes, the image frames are depicted with different shadings; no other meaning should be ascribed to the different shadings. For purposes of the example, all of the depicted image frames have a common image length, *w*₀, taken parallel to the axis 117. In general, however, the image lengths need not be identical. With the exception of image frame, f₃₃, only a portion (i.e., one eighth) of each image frame is depicted in the illustrated example, as every subsequent image frame is depicted as overlaying the respective preceding image frame.

Within the "central" portion of the sample 102 that is shown as having length, W, in Fig. 5, each sample point is imaged by eight separate image frames. The number of image frames in which a particular sample point appears progressively decreases both to the "left" and to the "right" (as depicted in the drawing) of this central sample portion. The creation of a composite image of the central portion of the sample benefits from maximum overlap, for purposes of either aligning images, discarding defective images, or supplying an adequate dose of electrons to the sample. Thus, in some instances, the length of a subsequently-constructed composite image may be limited to just the central portion of the sample 102 that is shown as having width, W. Nonetheless, with the exception of a portion of the sample that is nearest to the sample holder 114, every point on the sample is imaged in at least two image frames.

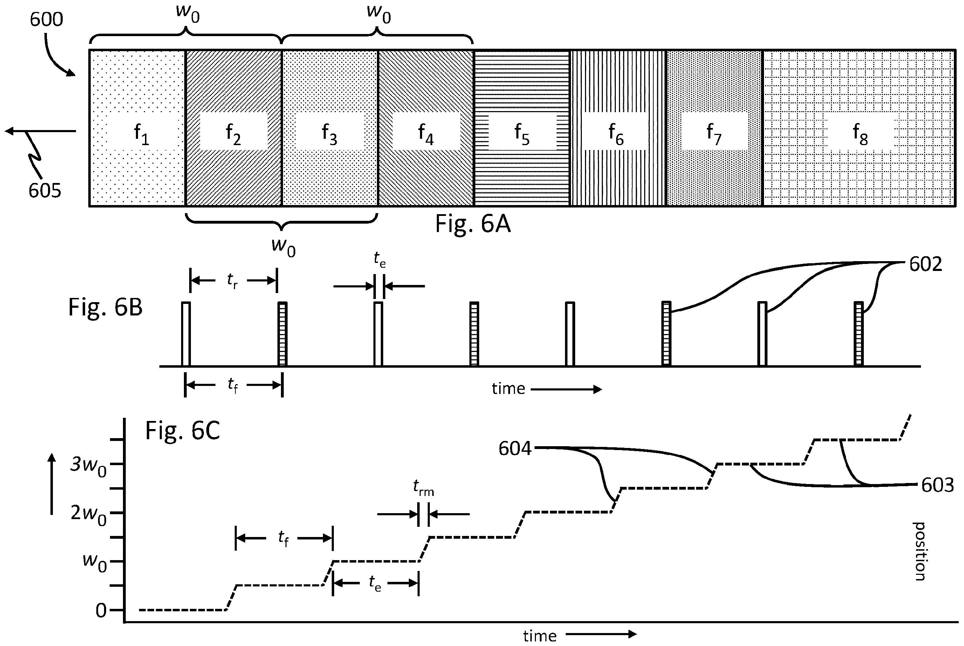

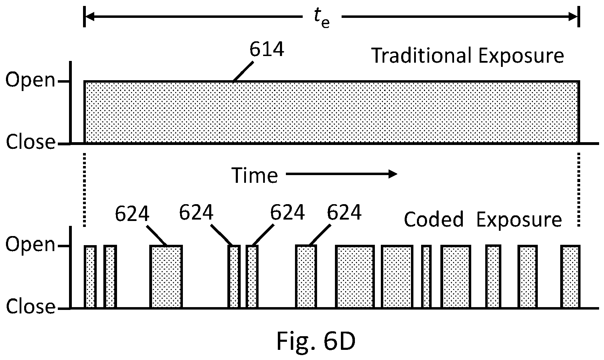

Fig. 6A is a schematic depiction of a set 600 of eight overlapping image frames, f₁ through f₈, each of length, *w*₀, as measured parallel to or substantially parallel to an axis about which the sample may be rotated, in which one-half of the length of each preceding image frame is overlapped by a respective subsequent image frame. The different shading patterns of the image frames do not have any significance other than as a means to distinguish between the frames. Figs. 6B, 6C and 6D schematically depict time sequences of events according to three separate modes of image data acquisition in accordance with the present teachings.

According to a first mode of operation (Fig. 6B), a sample is caused to continuously move, according to velocity vector 605, relative to an apparatus position at which pulses 602 of charged particles are caused to impact the sample, where each pulse corresponds to an exposure that generates a respective image frame of an image frame set. Such repeated exposure is referred to herein as "stroboscopic imaging" and the impact of each such pulse onto the sample is referred to herein, in analogy to optical photography, as an "exposure". According to the present teachings, the vector 605 (Fig. 6A) is either parallel to or substantially parallel to the axis about which the sample may be rotated. Generally, the exposures will be repeated with a constant time interval of *t*_{f}, which is referred to herein as the image frame time. According to the mode of operation depicted in Fig. 6B, the image frame time, *t*_{f}, is the greater of: (a) the time required for the continuous movement of the sample to translate the sample by a distance of (*w*₀/2) in preparation for a next exposure; or (b) the time required to read out image data of a prior exposure from a detector to computer memory. Generally, to avoid image blurring, the time duration, *t*ₑ, of each exposure may be made much shorter than *t*_{f}.

According to a second mode of operation (e.g., Fig. 6C), the sample is maintained stationary during each exposure, only being caused to move between exposures to the incident charged particle beam. Such procedures may be employed, for example, in situations in which relatively long exposures are required in order to improve image contrast or when image magnification is so great that any movement of the sample during an exposure would cause unacceptable blurring.

Fig. 6C depicts the position of an elongate sample, as measured parallel to a rotation axis and/or a sample elongation axis, as a function of time during such a procedure. In this figure, the times at which the sample is stationary are indicated as plateaus 603 and the times at which the sample is translated in preparation for a subsequent exposure are indicated as slopes 604. The time duration of the exposures (i.e., the "exposure time"), which is denoted as *t*ₑ in Fig. 6C, corresponds to the plateaus 603 at which the sample does not move. Although the exposure time, *t*ₑ, will generally be identical for all exposures that correspond to an image frame set or that correspond to a given sample, it is contemplated, in some situations, the various exposure times may vary within an image frame set or across image frame sets. The time duration between successive exposures of an image frame set (i.e., the "inter-exposure time"), which corresponds to the slopes 604 in Fig. 6C, is denoted as *t*ᵣₘ. During each inter-exposure period, of duration *t*ᵣₘ, the sample is translated, essentially parallel to an instrumental rotation axis or a sample rotation axis, in preparation for a subsequent exposure. During this same time period, image data corresponding to a prior exposure may be read out from a sensor into computer memory and the charged particle beam may be blanked. The inter-exposure time may also incorporate some dead time during which any residual positional drift relating to the preceding movement is allowed to subside. Accordingly, the image frame time, *t*_{f}, is the sum of the exposure time, *t*ₑ, and the inter-exposure time, *t*ᵣₘ. For overall efficiency, it is preferable that the inter-exposure time, *t*ᵣₘ, is as short as possible. Therefore, the charged particle microscope stage of the apparatus on which the sample is being imaged should comprise stage-translation actuators having fast response time and short-duration stabilization time.

As described in the preceding discussion, three-dimensional (3D) tomography methods in accordance with the present teachings employ constructing the 3D structural representation of an elongated sample or sample portion from a plurality of two-dimensional image strips, each of which is constructed by first acquiring, without rotating the sample, a plurality of image frames while moving the sample essentially parallel to or substantially parallel to an axis of elongation or a rotation axis. According to the first and second methods described above, any potential motion blur in the image frames that could potentially result from the sample movement is either minimized (i.e., by using pulsed exposures of short duration as in the described first mode of operation) or essentially completely eliminated (i.e., by only moving the sample between exposures as in the second described mode of operation).

According to a third mode of operation in accordance with the present teachings, motion blur is permitted to occur in the raw image frames while the sample is continuously translated, without stoppage between image frame acquisitions. Further, according to this third mode of operation, the motion blur is subsequently removed by a digital de-blurring technique, such as is described by Raskar et al. with regard to conventional optical photography (Raskar, Ramesh, Amit Agrawal, and Jack Tumblin. "Coded exposure photography: motion deblurring using fluttered shutter." In Acm Siggraph 2006 Papers, pp. 795-804. 2006). The digital de-blurring technique requires encoding of additional information within each set of raw image frames, where the encoding pertains to the motion of an imaged object. As described by Raskar et al., the encoding is performed, during acquisitions of images of the object as it moves within a camera's field of view by acquiring, within the period of time, *t*ₑ, that would ordinarily correspond to a single conventional exposure 614 (e.g., a single opening and closing of a shutter), a series of shorter-duration images 624, the timing and durations of which are determined in accordance with a binary pseudo-random sequence. Raskar et al. refers to this process as "fluttering" a shutter of the camera. However, with regard to the present disclosure, these shorter-duration exposures 624 are herein referred to as "partial image frame exposures".

Using the fluttering shutter image acquisition procedure described by Raskar et al., blurring will be observed within a single image frame that is obtained as the result of the accumulation of signal (pixel intensities) at a detector during such a set of partial image frame exposures. Nonetheless, within such a blurred image, details will be encoded within the blur patterns as recognizable variations in pixel intensity in the direction of motion. According to Raskar et al., this procedure provides a broad-band filter that preserves high-frequency spatial details in the blurred image such that subsequent deconvolution reconstruction of the details is a well-posed problem.

A charged particle beam microscope does not necessarily comprise a traditional mechanical shutter, as is commonly employed in optical photography. However, the same effect as shutter "fluttering", as described by Raskar et al., may be obtained by periodically blanking, in accordance with a binary pseudo-random sequence, a charged particle beam (e.g., beam 106 of Fig. 3) that is incident onto the sample while the sample is continuously in motion relative to the beam. Alternatively, the fluttering effect may be achieved by periodically diverting charged particles that have passed through a sample (e.g., sample 102) away from a detector (e.g., detector 112) by applying appropriate voltages, in accordance with the pseudo-random sequence, to a substage assembly (e.g., elements of objective lens system 110 or descanning unit 122) that is disposed between the sample and the detector. Alternatively, if the data readout is sufficiently fast, the same effect may be obtained by reading out data from the detector in accordance with the pseudo-random sequence.

According to methods of the present teachings, after all of the individual image frames of a single image frame set (e.g., one of the image frame sets C₁, C₂, etc. shown in Fig. 4B) have been acquired, a single composite image that comprises information from all of the image frames of the set is constructed. Each composite image is an elongated projection of the features and/or structure of a portion of the sample as taken at a particular angular orientation of the sample relative to a rotation axis and/or a sample elongation axis (i.e., the common angular orientation at which all image frames composing the image frame set were acquired). The construction of the composite image may be performed either prior to or during subsequent acquisition of image frames that correspond to a next image frame set (if any). Alternatively, the construction of all composite images - each corresponding to a respective image frame set - may occur only after all image frames of all image frame sets of a sample's region of interest have been acquired.

The process of constructing a composite image from a set of image frames may comprise correcting one or more of the individual image frames for astigmatism and/or other image distortions. The process of constructing the composite image may comprise de-blurring of one or more of the individual image frames, if necessary. The process of constructing the composite image may comprise, preferably subsequent to any image distortion and/or de-blurring steps, aligning the various image frames, one to another, by aligning portions of each of one or more overlapping images that correspond to a same region of the sample. If there are no overlapping regions between a pair of adjacent image frames or between several pairs of adjacent image frames, a composite image that includes those frames may nonetheless be constructing by estimating the displacement between the non-overlapping images based on approximate mechanical displacement vectors recorded by sensors during movement of a sample stage during acquisition of the images. In such cases, there may be gaps in the composite image that correspond to non-imaged portions of the sample. Nonetheless, such incomplete composite images may convey useful information about the structure of the sample. In some instances, the missing structural features may be reconstructed, within a two-dimensional composite image, by extrapolating features into the gap from the bounding image frames.

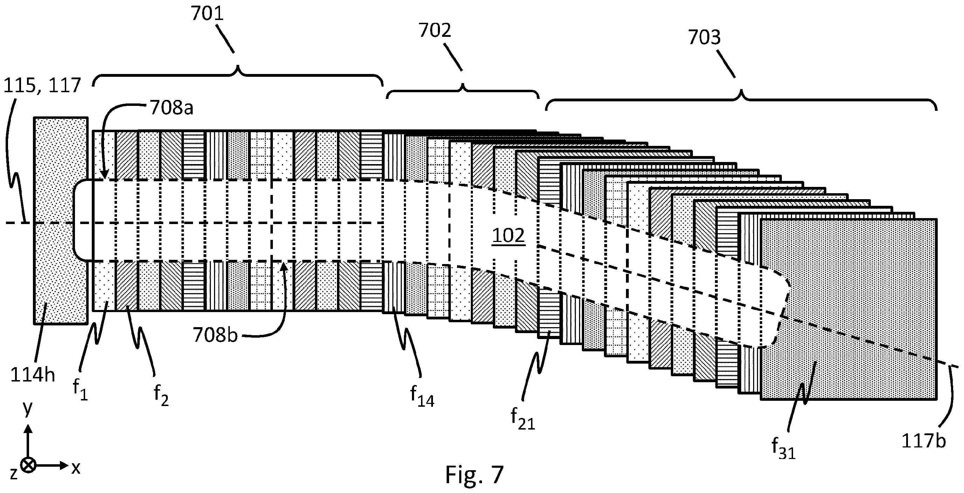

In some instances, a sample that is generally elongated may nonetheless not conform to a single axis of elongation. According to some methods in accordance with the present teachings, the procedures of acquiring multiple images along the length of the sample, as described previously herein, may be employed to detect such nonlinearities as well as other irregularities of the sample shape. For example, Fig. 7 depicts a hypothetical, generally-elongate, needle-like sample 102 mounted onto a movement stage 114 that has the capability to rotate the sample about the x-axis and the capability to translate the sample parallel to the x-axis. As depicted, the needle like sample is bent within a region 702 that separates otherwise straight elongate regions 701 and 703 having non-coincident elongation axes 117 and 117b, respectively, where axis 117 is also a rotation axis (e.g., the x axis of the stage apparatus) about which the sample may be rotated.

According to the various modes of operation that are described herein (see Figs. 5 and 6A-6C and the associated discussions), a method in accordance with the present teachings may commence acquisition of a plurality of overlapping image frames starting with image frame f₁ and proceeding to image frame f₂, etc. According to some variations of these methods, automated software may perform, for quality control purposes, rudimentary analyses of certain aspects of the images as they are being acquired, including edge detection analysis to determine potential irregularities in the shape of the sample. The values of the monitored parameters may be recorded versus time in order to compare later-acquired images with previous images. Preferably, such comparisons are performed automatically in real time.

Accordingly, with regard to the example of Fig. 7, the software may determine that, commencing at image frame f₁₄, the apparent center of the image of the needle (i.e., a point midway between the "topmost" boundary of the needle image 708a and the "lowermost" boundary of the needle image 708b as determined by edge detection) has departed from axis 117 in the negative y-axis direction. The software may then detect that the rate of further departure from the axis 117 progressively increases between image frame f₁₅ and image frame f₂₁, thereby indicating curvature of the needle. In some instances, the software may alert a user to the departure from linearity and either transmit an alert to a user or else abort the imaging procedure. Alternatively, if the movement stage 114 is configured with actuators that enable it to be translated parallel to the y-axis, the software may initiate translation of the movement stage 114 in the direction of the positive y-axis to bring the apparent center of the image of the sample into the center of the field of view. This procedure may be continued so as to continue to acquire the image frames f₂₂ through f₃₁.

Given the extreme deviation from linearity shown in Fig. 7, it may be impractical to rotate the sample about axis 117 to obtain additional composite images across the full length of the sample, since such necessary rotations about the axis 117 would bring portions of the sample 102 out of focus. With respect to the sample shape shown in Fig. 7, it would only be possible to perform a full 3D tomographic analysis of the sample portion that is closest to the movement stage. Nonetheless, by utilizing automatic edge detection in combination with automatic translational adjustments to compensate for the non-linearity, it still may be possible to generate at least one complete two-dimensional composite image. With less extreme deviations from linearity, it may be possible to proceed with the full 3D tomographic methods described herein by continuing to obtain additional two-dimensional composite images by rotating the sample about the axis 117.

Alternatively, if the movement stage comprises two or more independent rotation axes, then it may be possible to separately align each of the sample elongation axes 117 and 117b with an apparatus rotation axis 115. For example, if the apparatus rotation axis 115 is assumed to be fixed with respect to an apparatus reference frame and the movement state 114 further has the capability to rotate the sample about a second rotation axis (not shown) that is parallel to the z-axis and that is also assumed to be fixed with respect to the apparatus reference frame, then a rotation of the sample about the z-axis could bring the second elongation axis 117b into coincidence with the fixed rotation axis 115. Subsequently, a tomogram could also be constructed for the sample region 703 using the methods in accordance with the present teachings, as described above. Preferably, the movement stage (and/or the beam deflectors) also have the capability of translating the sample parallel to the y-axis, with respect to the charge particle beam.

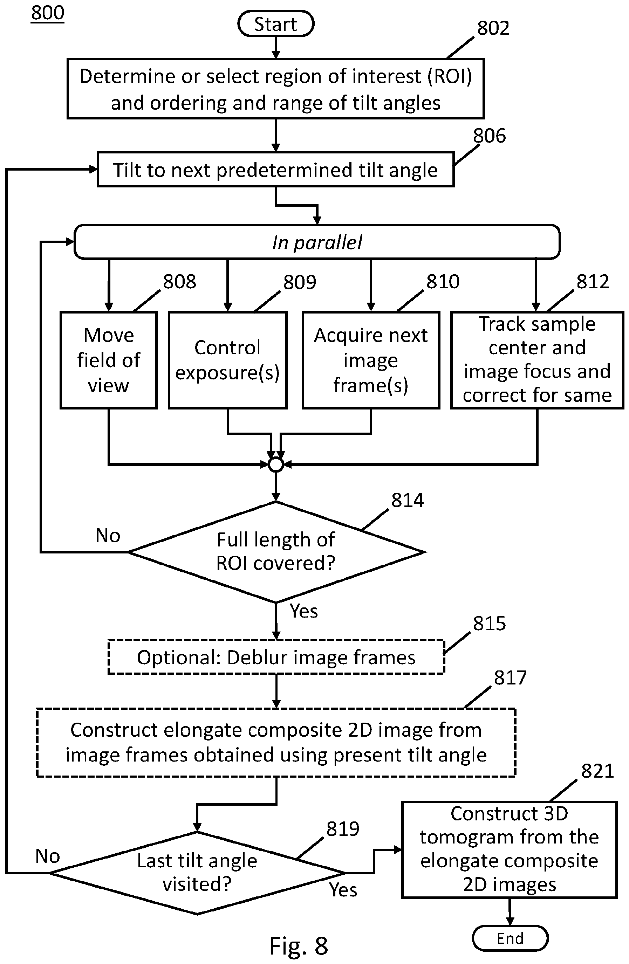

Fig. 8 is a flow diagram of a first exemplary method of three-dimensional tomographic analysis of an elongate sample or elongate sample portion in accordance with the present teachings. The method 800 pertains to image frame collection while the position of the sample, relative to an incident charged particle beam, is continuously moved. The movement of the sample relative to the incident charged particle beam may comprise one or both of: (a) movement of a movement stage to which the sample is mounted; and (b) movement of the incident charged particle beam. The latter type of movement may include deflection of a beam by a beam deflector 116 and/or repositioning of the beam by a sub-stage descanning unit 120 (Fig. 3).

In the first step, step 802, of the method 800, a region of interest along the length of the sample is either determined or selected. Further, a range of the tilt angles that are to be employed and the order in which the tilt angles are to be visited during the acquisition of sets of image frames are chosen. This step may include choosing an initial tilt angle, relative to a reference angular position and may also include choosing an angular increment by which the sample is to be rotated between acquisitions of sets of image frames. These choices may be made based on prior inspection of sample by either optical microscopy or charged particle beam microscopy.

The determination or selection of a sample region of interest in step 802 has implications for the determination of a region of the sample that is to be imaged. The region to be imaged is not necessarily identical to the region that is to be imaged. The determination of the latter region depends on whether or not the desired region of interest is to be imaged with sufficient redundancy. For example, only the sample points within the portion of the full length of the sample 102 designated by the dimension, *W,* in Fig. 5 are captured in each of eight separate image frames. In practice, the actual number of image frames in which a given portion of a sample is imaged is not limited to or restricted to any specific number. In many cases, the dimension, *W*₀, of the image frames is determined by the field of view of an imaging system. If, in such cases, it should happen that the portion of the sample that is designated by the dimension, *W,* is, in fact, the region of interest and it is desired for each point within the region of interest to be captured in at least eight image frames, then the additional image frames f₁ through f₇ must also be imaged.

In step 806 of the method 800 (Fig. 8), the sample is rotated to a first tilt angle. The following five steps - namely, steps 808, 809, 810, 812 and 814 are shown as being executed in parallel because, according the method 800, image frames are repeatedly acquired (step 810) with the tilt angle remaining fixed while, simultaneously with the repeated acquisitions, the position of the sample is continuously translated (step 808), relative to the charged particle beam, in a direction that is substantially parallel to a rotation axis. Step 808 also encompasses an initial translation of the sample, after setting of the tilt angle (in the prior execution of step 806), to a starting position along the length of the elongate sample prior to the image frame acquisitions at the fixed tilt angle. Each image frame acquisition commences with the initiation of an exposure (step 809) and ends with the termination of the same or a different exposure (step 809) and may include additional exposures (step 809) such as the plurality of partial image frame exposures 624 that are depicted in Fig. 6D. During the acquisition of the multiple exposures, the position of the sample relative to the center of the field of view may be tracked (step 812) and appropriate corrections for deviations may be made by adjustments made to the sample position, relative to an incident charged particle beam or by adjustments of beam focus. After each exposure, the position of the last acquired image frame is compared to a boundary of the region of interest (ROI), as selected in step 802; execution of the steps 808, 809, 810, 812 and 814 thus continues until the comparison indicates that the full length of the ROI has been imaged. The controlling of the exposures (step 809) may include one of more of: (a) blanking or un-blanking the transmission of a charged particle beam onto the sample; and (b) blocking or un-blocking the transmission of charged particles or photons from the sample to a detector. Any one of the blanking, un-blanking, blocking and un-blocking may include operating a shutter, which may comprise either an electronic shutter or a mechanical shutter.

Still with reference to the method 800 (Fig. 8), after the full length of the region of interest has been imaged, as determined in step 814, then at least step 819 is executed. Additionally, steps 815 and 817 may be executed prior to the execution of step 819. However, since the steps 815 and 817 are image processing steps, it is possible to alter the sequence of execution such that the steps 815 and 817 are executed after all image frames at all tilt angles have been acquired. Thus, the steps 815 and 817 are depicted with dashed lines to indicate that they may be alternatively executed after exiting the decision step 819 along its "Yes" branch and generally, but not necessarily, prior to execution of the step 821. Moreover, the steps 815, 817 and 821 may be swapped, interchanged or iterated in order to obtain an optimal two-dimensional image reconstruction or three-dimensional tomographic reconstruction. For purposes of description, the steps 815 and 817 are discussed below as if executed in the order shown in Fig. 8.

The optional step 815 may be required to remove image blurring caused by the continuous motion of the sample during the sequence of exposures that are used to acquire image frames at a particular tilt angle (e.g., the most recently employed tilt angle, as set in step 806). The de-blurring procedure may include the decoding of spatial details that are encoded within the variations of pixel intensities taken parallel to the direction of motion. Once all image frames have been acquired at the most recently set tilt angle and after any required deblurring operations have been carried out, then a composite two-dimensional image is constructed (step 817) from the full set image frames acquired that tilt angle. The construction of the composite image may include one or more of the steps of: digitally correcting image frames for astigmatism and other distortions; aligning image frames of an image frame set by recognizing imaged features that are common to more than one image frame; and, after alignment, co-adding or averaging image intensities of the set of image frames on a pixel-by-pixel basis. The co-adding or averaging procedure may include appropriate corrections to account for varying degrees of overlap of images across the sample (see Fig. 5 and the discussion thereof).

The execution of the method 800 repeatedly loops through the set of steps from 800 through 819, with each iteration of the loop comprising: (a) setting a new tilt angle; and (b) subsequently acquiring of a plurality of image frames along a length of the sample, where all of the image frames are acquired at that same tilt angle. Although the number of tilt angles that are employed and the order in which the tilt angles are visited may be pre-determined prior to the execution of the method 800, it is possible that some tilt angles may be determined during the execution of the method, based on results observed during prior image acquisitions. Optionally, each iteration of the loop may include the image data processing steps 815 and 817 in which the data of the most recently acquired set of image frames is optionally de-blurred and used to construct a two-dimensional (2D) image that corresponds to the most-recently set tilt angle. Otherwise, the steps 815 and 817 may be moved outside of the loop and prior to step 821, in which case they include optional de-blurring of all image frames acquired at all tilt angles and construction of a plurality of 2D images, each of which corresponds to a respective tilt angle. The resulting plurality of elongate 2D composite images comprise a simple tilt series, which may be subsequently employed, in step 821, to generate a three-dimensional model of the structure of the sample within the region of interest, using conventional tomographic techniques.

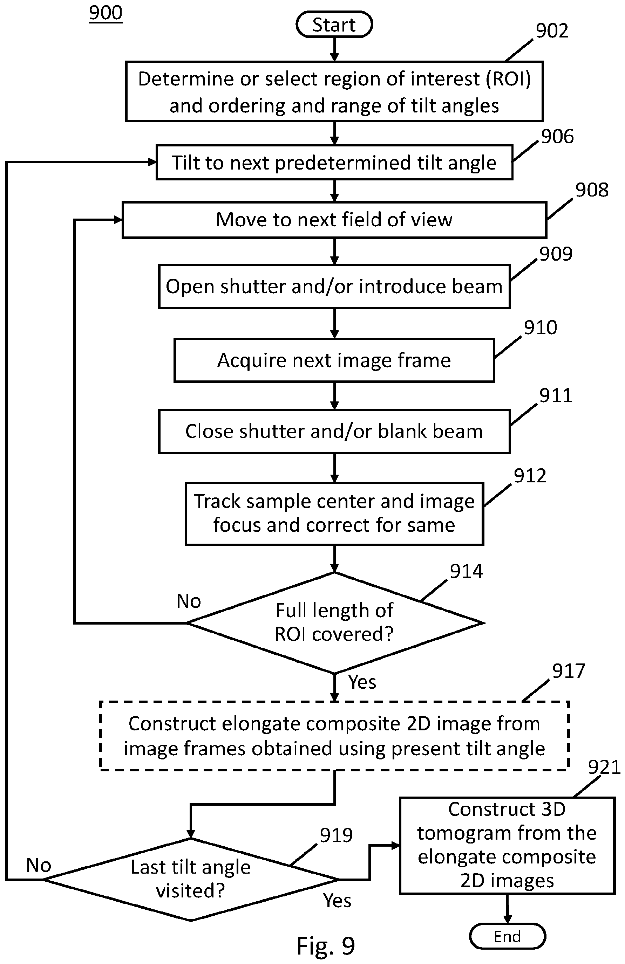

Fig. 9 is a flow diagram of a second exemplary method of three-dimensional tomographic analysis of an elongate sample or elongate sample portion in accordance with the present teachings. The method 900 of Fig. 9 pertains to image frame collection during discontinuous movement of the sample, relative to an incident charged particle beam, whereby image frame acquisition occurs only at times when there is no relative motion between the sample and the incident beam (e.g., when the sample is stationary) and such motion only occurs between image frame acquisitions. Steps 902, 906, 914, 917, 919 and 921 of the method 900 are either identical or similar to the steps 802, 806, 814, 817, 819 and 821, respectively, of the method 800 and, thus, these steps are not further described here. Steps 908-912 of the method 900 are similar to the steps 808-812 of the method 800. However, whereas the steps 800-812 are repeatedly executed in parallel, the steps 908-912 are executed in an appropriate sequence. Thus, the movement of the sample and/or beam to the next field of view (step 908) necessarily occurs before the opening of a shutter or the introduction of a charged particle beam onto the sample (step 909). Likewise, the step of shutter opening or beam introduction (step 909) necessarily occurs before acquisition of an image frame (step 910) which is naturally followed by shutter closing or beam blanking (step 911) and sample position tracking (step 912). Similarly, to the step 817, the step 917 relates only to processing of image data and therefore may be executed subsequent to exiting the decision step 919 along its "Yes" branch and prior to execution of step 921.

As noted herein, certain steps of methods disclosed herein pertain to image data processing, including tomographic reconstructions. In particular examples, the tomographic reconstructions and other data processing steps may be performed remotely, e.g., in a distributed computing environment, to improve processing speeds or address onerous computational loads. Various tomographic reconstruction techniques can be employed, including iterative approaches, search, expectation maximization, weighted back-projection, etc. Images can be stored and resorted where necessary so that the acquired image sequences can be tailored or adapted to standard reconstruction techniques.

Image acquisition algorithms that leverage beam deflection, beam blocking, beam blanking, detector shuttering, etc. can be embodied as software or firmware instructions carried out by a digital computer local to a charged particle beam (CPB) microscopy system. For instance, any of the disclosed techniques can be performed by a computer or other computing hardware that is part of or coupled to a CPB microscopy system, such as a transmission electron microscope (TEM) system or a scanning electron microscope (STEM) system. For instance, software for performing any of the disclosed embodiments can be stored on the one or more volatile, non-transitory computer-readable media as computer-executable instructions, which when executed by the one or more processors, cause the one or more processors to perform any of the disclosed techniques. The results of the image acquisitions, computations, or reconstructions can be stored (e.g., using suitable data structures or lookup table) in the one or more tangible, non-transitory computer-readable storage media and/or can also be output to the user, for example, by displaying data, images, tomographic image slice, 3D reconstructions, etc., on a display.

The herein-described three-dimensional tomography methods provide several advantages over conventional tomography methods that rely on either tilt-series or helical image acquisition. Firstly, with regard to radiation-sensitive samples, the methods disclosed herein can ensure that equal dosages of charged particles, during image acquisition, over an entire region of interest or over an entire sample. This is in contrast to image acquisitions that employ normal tilt series or helical tomography, during which it is difficult to ensure that all areas of the sample receive equal quantities of charged particles, a condition that is crucial to preventing image artefacts. Secondly, the disclosed methods enable the simplification of the stitching problem. The act of stitching separate three-dimensional reconstruction volumes or separate tilt series is notoriously difficult. By employing the novel methods disclosed herein, the only image stitching that may be required is the less-difficult procedure of stitching adjacent two-dimensional images having large overlaps. In some cases (e.g. when using well-calibrated image-beam-shift optics that maintain accurate records of image frame locations), stitching may not be needed at all. Thirdly, the methods disclosed herein facilitate more rapid image acquisition in comparison to helical or normal tomography acquisition in which many more tilt steps are required. Finally, the herein-disclosed methods enable tracking of the position of an elongate sample or sample while imaging at each tilt angle, which provides near-real-time information on the tilt position and curvature of the sample or sample portion and thereby allows for stage movement corrections to be applied in near real time. Such information can also provide useful extra metadata which can be used to constrain three-dimensional reconstruction algorithms.

### Additional Examples

In addition to the foregoing description, methods in accordance with the present disclosure may comport with any one of or several of the following listed items:
Item 1. A method of three-dimensional (3D) tomography comprising:
   providing a sample comprising an elongate section, the elongation of which defines an elongation axis having an axis length;
   acquiring, with a charged particle beam microscope, a plurality of two-dimensional (2D) composite images of the elongate section along its axis length, each 2D composite image being generated from a respective series of image frames and corresponding to a projection of the elongate section that is parallel to the elongation axis, wherein each 2D composite image is acquired at a different respective angle of rotation of the sample, relative to an initial orientation of the sample, about a rotation axis that is substantially coincident with the elongation axis; and
   combining the plurality of 2D composite images to obtain a 3D tomographic representation of the elongate section of the sample.
Item 2. A method of 3D tomography as recited in item 1, wherein all images of each series of image frames correspond to a same angle of rotation of the sample about the rotation axis, relative to the initial orientation, each image frame of each series of image frames corresponding to a 2D projection image of the elongate section along a portion of its length.
Item 3. A method of 3D tomography as recited in item 2, wherein each image frame of each series overlaps at least one other adjacent image frame of the same series.
Item 4. A method of 3D tomography as recited in item 2, wherein there is no overlap of image frames within each series and wherein each 2D composite image of the elongate section across its length is generated from the non-overlapping image frames of the corresponding series of image frames by digital reconstruction of sample features between consecutive frames.
Item 5. A method of 3D tomography as recited in any one of items 2-4, wherein each image frame of each series of image frames is generated by detection of a response of the sample to a pulse of a beam of incident electrons or ions onto a portion of the sample, wherein the relative positions of the sample and the beam are varied between successive pulses.
Item 6. A method of 3D tomography as recited in any one of item 5, wherein the acquiring of each 2D composite image comprises acquiring at least one image frame using a transmission electron microscope (TEM) image.
Item 7. A method of 3D tomography as recited in any preceding item, wherein a thickness of the elongate section, taken perpendicular to the elongation axis, is not greater than one micrometer (µm).
Item 8. A method of 3D tomography as recited in any preceding item, wherein the acquiring of each 2D image comprises acquiring at least one image of the emission of photons from the sample in response to impingement of electrons or ions onto the sample.
Item 9. A method of 3D tomography as recited in any one of items 1-8, wherein the providing of the sample that comprises the elongate section comprises creating the elongate section by ion beam milling of the sample.
Item 10. A method of 3D tomography as recited in any one of items 1-9, wherein the plurality of angles of rotation of the sample, relative to the initial orientation of the sample, range between ninety degrees and negative ninety degrees.
Item 11. A method of 3D tomography as recited in any one of items 2-4, wherein the acquiring of each series of image frames comprises varying, between acquisitions of successive image frames, a position of the sample relative to an incident flux of photons, electrons or ions that are directed onto the sample.
Item 12. A method of 3D tomography as recited in item 11, wherein the relative positions of the sample and the incident flux are continuously varied during the acquiring of each series of image frames.
Item 13. A method of 3D tomography as recited in item 12, wherein each image frame of each series of image frames corresponds to a respective time increment during which the sample is exposed to the incident flux, wherein the timing of the pulses of the incident flux is in accordance with a pseudo-random sequence.
Item 14. A method of 3D tomography as recited in item 11, wherein movement of the sample relative to the incident flux is reversed after the acquiring of each series of image frames.
Item 15. A method of 3D tomography as recited in any preceding item, further comprising:
   detecting, based on at least one of the 2D images, a second elongate section of the sample, the elongation of the second elongate section defining a second elongation axis having a second axis length;
   acquiring, using the charged particle beam microscope, a second plurality of 2D composite images of the second elongate section along the second axis length, each of the second plurality of 2D composite images being generated from a second corresponding to a projection of the second elongate section.
Item 16. A method of 3D tomography as recited in any one of claims 2-4, wherein the acquiring of each image frame comprises accumulating image data from a plurality of partial image frame exposures, wherein the timing of each partial image frame exposure is controlled by a pre-determined binary pseudo-random sequence.
Item 17. A method of 3D tomography as recited in any one of claims 2, 3, 4 and 16, further comprising de-blurring an image frame.
Item 18. A charged particle beam apparatus comprising:
   a source of charged particles;
   a charged particle beam column configured to direct a beam of charged particles from the source of charged particles onto an elongate portion of a sample mounted on a rotatable and translatable sample stage;
   charged particle beam optics or photonic optics configured to transfer, to a detector, either charged particles or photons either transmitted through or generated at the sample in response to the impingement of the beam of charged particles onto the sample, wherein the transfer of the charged particles or photons comprises generation of an image frame that is a projection of the features and/or structure of the elongate section along a portion of its length; and
   a controller environment electrically coupled to one or more of the source of charged particles, the rotatable and translatable sample stage, the charged particle beam optics or photonic optics and the detector, the controller environment comprising program instructions that are operable to execute the method of any one of items 1-17.
Item 19. A computer program product comprising program instructions that, when executed on a controller environment of a 3D tomographic imaging system, are operable to execute the method of any one of items 1-17.

## Claims

1. A method of three-dimensional (3D) tomography comprising:
providing a sample comprising an elongate section, the elongation of which defines an elongation axis having an axis length;
acquiring, with a charged particle beam microscope, a plurality of two-dimensional (2D) composite images of the elongate section along its axis length, each 2D composite image being generated from a respective series of image frames and comprising a projection of the elongate section that is parallel to the elongation axis, wherein each 2D composite image is acquired at a different respective angle of rotation of the sample, relative to an initial orientation of the sample, about a rotation axis that is substantially coincident with the elongation axis; and
combining the plurality of 2D composite images to obtain a 3D tomographic representation of the elongate section of the sample.

2. A method of 3D tomography as recited in claim 1, wherein all image frames of each series of image frames correspond to a same angle of rotation of the sample about the rotation axis, relative to the initial orientation, each image frame of each series of image frames corresponding to a 2D projection image of the elongate section along a portion of its length.

3. A method of 3D tomography as recited in claim 2, wherein the acquiring of each series of image frames comprises varying, between acquisitions of successive image frames, a position of the sample relative to an incident flux of charged particles that are directed onto the sample.

4. A method of 3D tomography as recited in claim 3, wherein each image frame of each series overlaps at least one other adjacent image frame of the same series.

5. A method of 3D tomography as recited claim 3, wherein there is no overlap of image frames within each series and wherein each 2D image of the elongate section across its length is generated from the non-overlapping image frames of the corresponding series of image frames by digital reconstruction of sample features between adjacent image frames.

6. A method of 3D tomography as recited in any one of claims 1-5, wherein the plurality of angles of rotation of the sample, relative to the initial orientation of the sample, range between ninety degrees and negative ninety degrees.

7. A method of 3D tomography as recited in any one of claims 3-6, wherein a direction of relative movement of the sample relative to the incident flux is reversed after the acquiring of each series of image frames.

8. A method of 3D tomography as recited in any one of claims 3-7, wherein each image frame of each series of image frames corresponds to a respective time increment during which the sample is exposed to a plurality of pulses of the incident flux, wherein the timing of the pulses of the incident flux is in accordance with a pseudo-random sequence.

9. A method of 3D tomography as recited in any one of claims 3-7, wherein each image frame of each series of image frames corresponds to a respective time increment during which a detector is exposed to a plurality of pulses of a flux of electrons from the sample to the detector, wherein the timing of the pulses of the flux is in accordance with a pseudo-random sequence.

10. A method of 3D tomography as recited in any preceding claim, further comprising:
detecting, based on at least one of the 2D images, a second elongate section of the sample, the elongation of the second elongate section defining a second elongation axis having a second axis length;
acquiring, using the charged particle beam microscope, a second plurality of 2D composite images of the second elongate section along the second axis length, each of the second plurality of 2D composite images being generated from a respective series of image frames and comprising a projection of the second elongate section that is parallel to the second elongation axis, wherein each of the second plurality of 2D composite images is acquired at a different respective angle of rotation of the sample, relative to an initial orientation of the sample, about a second rotation axis that is substantially coincident with the second elongation axis; and
combining the second plurality of 2D composite images of the second elongate section to obtain a 3D tomographic representation of the second elongate section of the sample.

11. A method of 3D tomography as recited in any preceding claim, wherein a thickness of the elongate section, taken perpendicular to the elongation axis, is not greater than one micrometer (µm).

12. A method of 3D tomography as recited in any preceding claim, wherein the acquiring of each 2D composite image comprises acquiring at least one image of the emission of photons from the sample in response to impingement of electrons or ions onto the sample.

13. A method of 3D tomography as recited in any one of claims 3-7, wherein the relative positions of the sample and the incident flux are continuously varied during the acquiring of each series of image frames.

14. A charged particle beam apparatus comprising:
a source of charged particles;
a charged particle beam column configured to direct a beam of charged particles from the source of charged particles onto an elongate portion of a sample mounted on a rotatable and translatable sample stage;
charged particle beam optics or photonic optics configured to transfer, to a detector, either charged particles or photons either transmitted through or generated at the sample in response to the impingement of the beam of charged particles onto the sample, wherein the transfer of the charged particles or photons comprises generation of an image frame that is a projection of the elongate section along a portion of its length; and
a controller environment electrically coupled to one or more of the source of charged particles, the rotatable and translatable sample stage, the charged particle beam optics or photonic optics and the detector, the controller environment comprising program instructions that are operable to execute the method of any one of claims 1-13.

15. A computer program product comprising program instructions that, when executed on a controller environment of a 3D tomographic imaging system, are operable to execute the method of any one of claims 1-13.
